Europäisches Patentamt

(19) European Patent Office

Office européen des brevets

(11) Publication number: **0 019 412**
A1

(12) **EUROPEAN PATENT APPLICATION**

(21) Application number: 80301485.1

(22) Date of filing: 07.05.80

(51) Int. Cl.³: **H 03 L 7/18**
H 03 B 21/02, H 03 K 21/36

(30) Priority: 09.05.79 GB 7916053

(43) Date of publication of application:
26.11.80 Bulletin 80 24

(84) Designated Contracting States:
CH DE FR IT LI NL SE

(71) Applicant: THE MARCONI COMPANY LIMITED
Marconi House New Street
Chelmsford Essex CM1 1PL(GB)

(72) Inventor: Sosin, Boleslaw Marian
"Frampton" Main Road
Boreham Chelmsford, Essex(GB)

(74) Representative: Hoste, Colin Francis
The Marconi Company Limited Marconi House New
Street
Chelmsford, Essex CM1 1PL(GB)

(54) A method of synthesizing an output frequency and circuit arrangement therefor.

㋷ A frequency synthesiser receives a sequence of digital pulses (Fq) and provides as an output a lower frequency consisting of a slightly irregular sequence of pulses. The synthesiser divides the received frequency by a non-integral value by arranging for a variable frequency divider (5) to divide the received sequence of pulses and by periodically removing the received pulses prior to division so as to in effect, temporarily alter the division ratio.

EP 0 019 412 A1

./...

Croydon Printing Company Ltd.

Fq

PULSE
SUBTRACTOR

F2

3

SHIFT
REGISTER

16

17

PULSE
SUBTRACTOR

CALCULATOR

15

4

FRACTIONAL
LATCH

VARIABLE
FREQUENCY
DIVIDER

10

5

INTEGRAL
LATCH

9

CALCULATOR

8

7 — FREQUENCY SELECTOR

F1

6

FIG.2.

## Frequency synthesisers

This invention relates to frequency synthesisers in which a frequency having a value which is variable in a controlled manner can be derived from another frequency, which may be a standard frequency or one harmonically related to a standard frequency. In those cases where the required frequency is an integral fraction of the other frequency, it can easily be derived by means of a simple frequency division process, but greater difficulties are present if it is not an integral fraction of the first frequency nor differs by an integral fraction from it. In these cases a simple frequency division is not possible and it has been proposed to use some form of pulse subtraction technique in which a correct number of pulses are produced in a unit of time so as to correspond to the required frequency, but the pulses are necessarily placed at irregular intervals causing a certain amount of frequency jitter to be present in the signal so produced. In known arrangements, the frequency jitter is often unacceptably large and the present invention seeks to provide a frequency synthesiser in which this disadvantage is reduced to a minimum.

According to one aspect of this invention, a method of synthesising an output signal having a mean frequency from a higher frequency by dividing the higher frequency by a non-integral divisor value having an integral portion and a fractional portion includes the steps of receiving digital pulses at said higher frequency; frequency dividing said higher frequency by said integral portion of the divisor value to produce a stream of pulses; providing a control signal derived from a succession of cumulative sums of the fractional portions of the divisor values and which is indicative of fractional portions of the cumulative sums which exceed a predetermined amount; and utilising said control signal to remove a pulse from said received digital pulses prior to frequency division in response to the generation of a pulse in said stream of pulses.

According to a further aspect of this invention, a frequency synthesiser which synthesises an output signal having a particular mean frequency from a higher frequency by dividing the high frequency by a non-integral divisor value having an integral portion and a fractional portion includes means for receiving digital pulses at said higher frequency; a frequency divider for dividing said higher frequency by said integral portion of the divisor value to produce a stream of pulses; means for providing a control signal derived from a succession of cumulative sums of the fractional portions of the divisor values and which is indicative of fractional portions of the cumulative sums which exceed a predetermined amount; and means for utilising said control signal to remove a pulse from said received digital pulses prior to frequency generation in response to the generation of a pulse in said stream of pulses.

The said stream of pulses represents a signal having said particular mean frequency in which the phase irregularities of the individual pulses are minimised. Thus the frequency jitter is also minimised. This signal may be used as an output signal, if required, or it may be subtracted from the received higher frequency to form a difference frequency. In order to keep the frequency jitter in the final output signal to a minimum, the frequency of said stream of pulses should be very much less than the said higher frequency. Thus if an output frequency of just less than said higher frequency is required, it should be obtained by deriving a complement of the frequency of said stream of pulses in accordance with the above method and subtracting the complement from said higher frequency.

Preferably said predetermined amount is unity. When the cumulative sum exceeds unity, preferably an amount equal to unity is removed from the cumulative sum to leave a fractional portion of less than unity.

In one embodiment of the present invention the cumulative summation is performed in a summation circuit which is clocked by means of pulses of said stream of pulses, so that the fractional portions are cumulatively summed each time a pulse of said stream of pulses is produced.

Preferably again each time said fractional portion of said cumulative sum exceeds the predetermined amount, the output of the summation circuit enables a pulse subtractor to remove the pulse from said received digital pulses.

Preferably yet again the summation circuit controls a gate which when opened allows a single pulse of said stream of pulses to pass to said pulse subtractor.

In another embodiment of the present invention all successive values of the cumulative sum are initially calculated and then stored so as to enable a pulse to be removed from said received digital pulses as required in response to pulses in said stream of pulses.

Preferably again storage means are provided for storing a sequence of digits, a first digital value or a second digital value being produced when the fractional portion of the cumulative sum is respectively greater or less than the predetermined amount, clocking means for reading said storage means under the action of clock signals derived from said stream of pulses, whereby a pulse is removed from said received digital pulses prior to frequency division each time a said first digital value is read from the store.

The method of synthesising a signal as described above may be used to provide a required variable frequency output signal or alternatively may be used as an intermediate stage in a more complex multi-stage frequency synthesiser.

An output frequency Fl which is a non-integral fraction of a higher frequency Fq is produced by dividing the higher frequency by a divisor K, where K is the sum of an integral divisor value i and a fraction divisor value f. Thus

$$\frac{Fq}{i + f} = Fl \qquad (1)$$

Re-arranging this gives equation

$$\frac{Fq}{Fl} = i + f \qquad (2)$$

and a further re-arrangement gives

$$Fl = \frac{Fq - f.Fl}{i} \qquad (3)$$

which is more clearly indicative of the mode of operation of the frequency synthesiser.

In equation (3) the term f.Fl is, of course, fractional and it is subtracted from Fq at intervals when it exceeds the predetermined value, which in the preferred embodiment of the invention is unity.

The way in which the invention is implemented is described by way of example with reference to the accompanying drawings in which,

Figure 1 shows a frequency synthesiser in accordance with the present invention,

Figure 2 shows a modification thereof, and

Figures 3, 4 and 5 show multi-stage frequency synthesisers incorporating a circuit of the kind shown in Figures 1 or 2.

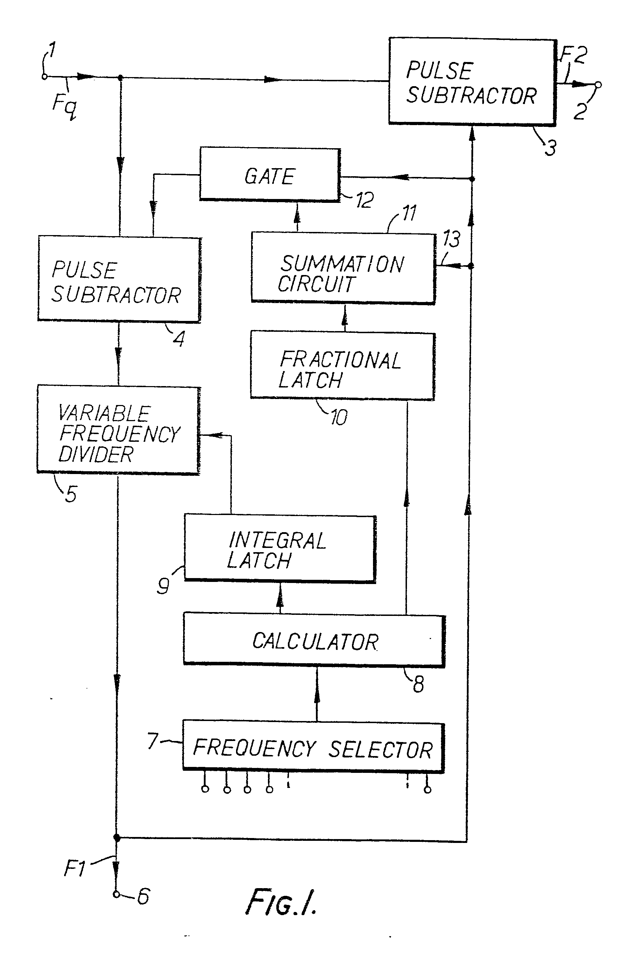

Referring to Figure 1, a relatively high frequency Fq is applied to input terminal 1 and is passed via a pulse subtractor 3 to an output terminal 2 and also via a further pulse subtractor 4 and a variable frequency divider 5 to a second output terminal 6. The required frequency which is to be produced at output terminal 6 is entered into a frequency selector 7, which conveniently may consist of a digital keyboard by means of which the required frequency can be entered into a calculator 8. The calculator may be a relatively simple device, and in essence it serves to perform the calculation set out in equation 2. The result of this calculation produces an integral divisor value i and a fractional divisor value f, the first of which is entered into and stored in an integral latch 9 and the second of which is entered into a fractional latch 10. The integral latch 9 is used to set the divisor value of the variable frequency divider 5 and the fractional latch 10 is used to control the operation of a summation circuit 11, which receives pulses from the output of the variable frequency divider 5 over line 13. The variable frequency divider 5 also supplies pulses to the pulse subtractor 3 and to a gate 12 which is operated under control of the summation circuit 11. The output of the gate 12 controls the pulse subtractor 4.

The operation of the circuit shown in Figure 1 is as follows. As previously described, the calculator 8 performs a straightforward arithmetical function by dividing the value of the frequency Fq present at terminal 1 by the frequency Fl which is required at output terminal 6. For this purpose, the value of frequency Fl is entered into the calculator 8 via the frequency selector 7 and it is assumed that the value of frequency Fq is stored internally in calculator 8 or is otherwise entered in as required. This calculation is performed as and when a new frequency Fl is entered into the frequency selector 7 and the values of i and f are stored in the latches 9 and 10 respectively once they have been calculated, thereby freeing the calculator to perform other functions as required. For example, if the frequency synthesiser shown in Figure 1 is merely an intermediate stage of a more complex multi-stage frequency synthesiser, the calculator may be used to provide arithmetical functions for the remaining stages.

The integral divisor value i is used to set the division ratio of the variable frequency divider 5, but the fractional divisor value f is summed cumulatively by the summation circuit 11, an additional summation being performed each time a pulse is received via input line 13 from the variable frequency divider 5. Thus the input line 13 acts as a clock source for the summation circuit. The fractional values f are summed cumulatively until the sum exceeds a predetermined value, in this case unity. When the sum exceeds unity the gate 12 is opened temporarily under the action of a control signal from the summation circuit 11 to allow the next output pulse obtained from the variable frequency divider 5 to pass through the gate 12 to the pulse subtractor 4, where a single pulse is subtracted from the pulse stream obtained via terminal 1. In so doing the effective division ratio of the variable frequency divider 5 is temporarily increased by one unit, thereafter normal division continues until the next occasion that the cumulative sum produced by the summation circuit 11 exceeds unity.

The output frequency F1 of equation 1 is thus produced at output terminal 6 and the difference frequency F2 equal to Fq - F1 is produced at output terminal 2, since the pulse subtractor 3 serves to subtract pulses representative of frequency F1 from the input frequency Fq present at terminal 1.

Since the calculator 8 is required to perform only the initial calculation represented by equation 2, it may, if desired, be used to calculate the cumulative sum during the normal operation of the frequency synthesiser, thereby avoiding the need to provide a separate summation circuit, but will be necessary to provide a threshold circuit or instruction for the calculator 8 to determine when the threshold of unity is exceeded.

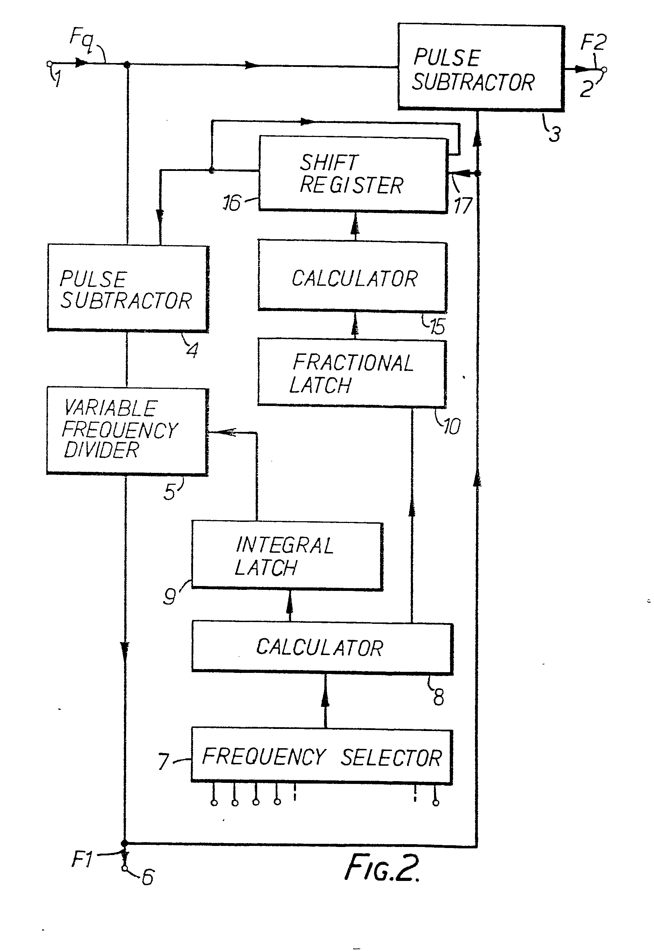

A modified circuit is illustrated in Figure 2 in which cumulative sums are performed initially in a calculator 15 when the required frequency value is entered into the frequency selector 7. Those circuit components which are the same as those shown in Figure 1 bear like reference numerals. When the entire summation calculation is initially performed in calculator 15 digital 'one' values are entered into and stored in a shift register 16 for those cumulative sums which exceed the threshold value (which is unity) and digital 'zero' values are entered and stored for those cumulative sums which come to less than the threshold value. The operation of generating digital 'one' and 'zero' values is performed until the fractional remainder is either zero or sufficiently close to zero to be ignored. In some cases a very large number of digits may need to be stored in the shift register, possibly as many as a thousand bits. The output pulses of frequency F1 are applied over line 17 to the shift register 16, which shifts the digital values in the shift register by one position and a pulse of frequency Fq is subtracted at the pulse subtractor 4 by means of a control signal from the shift register 16 if the value in the first stage of the shift register 16 is a digital 'one' but no pulse is subtracted if a digital 'zero' is present.

Because of the way in which the output frequency F1 present at output terminal 6 has been calculated, it possesses the minimum theoretically possible jitter frequency. As the frequency F1 is not an integral fraction of the received frequency Fq, the value of the jitter frequency cannot be zero, but for values of the frequency F1 which are significantly less than the received frequency Fq, the value of the jitter frequency is very low. Thus when a relatively low output frequency is required, it will be obtained from output terminal 6. However, if a relatively high output frequency is needed which is only a little less than the value of frequency Fq, an excessive jitter frequency would be present if it were obtained directly as described above. For this reason, the value of frequency F1 is made the complement of the required frequency F2 and the frequency F2 is obtained at output terminal 2 by subtracting the value of frequency F1 from that of frequency Fq by a simple pulse subtraction technique using the pulse subtractor 3 as previously mentioned.

The frequency synthesisers illustrated in Figures 1 and 2 provide as outputs a string of pulses in which the phase jitter is minimised and for this reason the circuits are conveniently referred to as pulse string synthesisers. If the pulse string synthesiser is to be used as simply one stage in a multi-stage frequency synthesiser, it may be positioned and operated in a variety of ways. Because of the limit on the maximum speed of operation of the logic circuit elements shown in Figures 1 and 2 and because of the requirement that F1 should be a small fraction of Fq, the use of frequency F1 as an output frequency is restricted to fairly low frequency applications. In order to obtain a proper sine wave output the string of pulses at frequency F1 may be passed though a low pass filter or a tuned filter or even through a phase lock loop which is simply used to clean up and remove the remaining frequency jitter. The use of a phase lock loop for this purpose is well known and it will be appreciated that the pulse string synthesiser acts in this application as a signal source only. A phase lock loop connected to the output of the pulse string synthesiser may be used to multiply the frequency of the output signals as required, but a limit will soon be reached since the jitter frequencies are also multiplied and may soon become unacceptable.

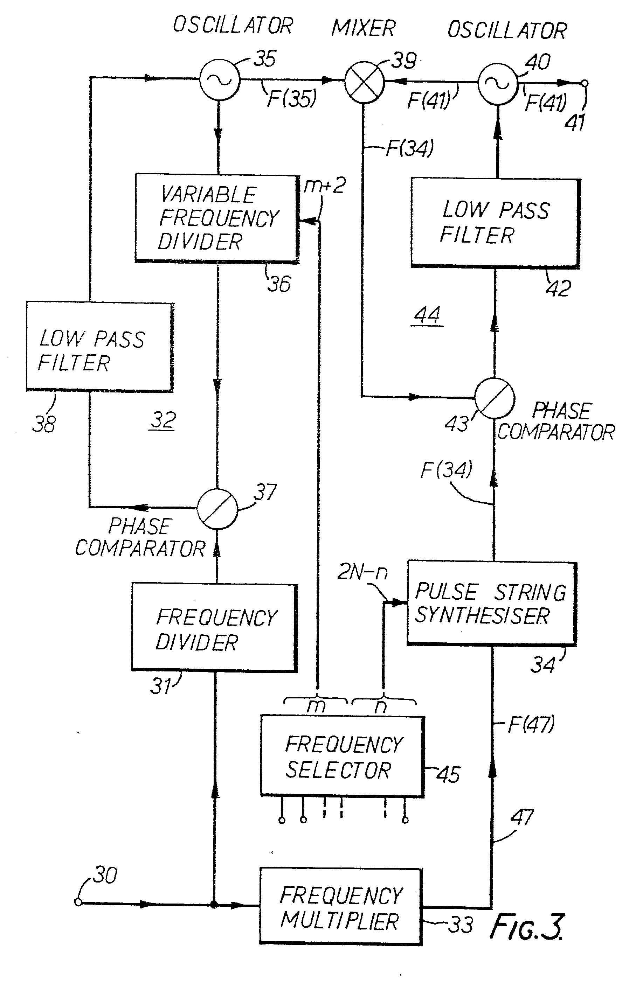

Examples of multi-stage frequency synthesiser with which the pulse string synthesiser can be advantageously used are described with reference to Figures 3, 4 and 5.

Referring to Figure 3, a multi-stage frequency synthesiser receives a standard high frequency signal at a terminal 30, which is passed via a fixed frequency divider 31 to a first phase lock loop 32 and also via a frequency multiplier 33 to a pulse string synthesiser 34 which could be as illustrated in Figures 1 or 2. The phase lock loop 32 consists of a variable frequency oscillator 35, the output frequency of which is divided by a variable frequency divider 36 and the divided frequency is compared with the frequency obtained from frequency divider 31 by a phase comparator 37 and the resulting signal is passed via a low pass filter 38 to the frequency control input of the oscillator 35 so as to stabilise its frequency.

The output of the oscillator 35 is applied to a mixer 39, where it is mixed with the output of a further oscillator 40. The mixed signal provided by the mixer 39 is applied as one input of a phase comparator 43, the other input of which is obtained from the pulse string synthesiser 34. The output of the phase comparator 43 is applied via a low pass filter 42 to the oscillator 40, so as to control its frequency. The output

of the oscillator 40 is provided at an output terminal 41.

The operation of the circuit shown in Figure 3 is as follows.

The phase lock loop 32 can be of standard design and the low pass filter 38 is arranged to stop the frequency of the step intervals of the phase lock loop. In this example, it is assumed that the oscillator 35 provides an output which covers a frequency range 60 to 90 MHz in 10 kHz steps, and a standard frequency of 1 MHz is applied to terminal 30. The phase lock loop 44 operates as a subtraction loop where the frequency of the output oscillator 40 is raised by the frequency F2 provided by the pulse string synthesiser 34, which frequency F2 is available in small frequency steps. In this case, the frequency F1 output of the pulse string synthesiser 34 is not used, since its use would not offer any advantage over the use of a third phase lock loop in its place because in this case the frequencies of the two oscillators 35 and 40 would be very close thereby introducing design difficulties. The use of the output frequency F2 allows frequency separation of these oscillators 35 and 40, whilst retaining the ability to provide an output frequency which is adjustable by very small frequency steps. The filter 42 is arranged to stop the frequency F1 which is present in the frequency F2 as a jitter frequency.

Ideally the value of frequency F1 is of the same order of magnitude as the step frequency of the phase lock loop 32, i.e. 10 kHz in this example. The required frequency division values are entered into the variable frequency divider 36 and the appropriate circuits of the pulse string synthesiser 34 from a frequency selector 45.

Conveniently the frequency selector 43 may be the frequency selector illustrated in Figures 1 and 2, but it is represented separate from the pulse string synthesiser 34 so as to indicate the way in which the most significant bits and the least significant bits of the required frequency are used to set up the variable frequency divider 36 and the operation of the pulse string synthesiser 34. The required frequency value is entered into the frequency selector 45 in the form of m + n, where m represents the most significant digits of the frequency value, and n the least significant digits. However, the value of m itself is preferably not used as the divisor value for the variable frequency divider 36. By way of example, if in practice an output frequency of, say, 23511283 Hz is required, then m = 2351 and n = 1283. In general if the required output frequency at terminal 41 is F(41) then m = F(41).N, where in this example N = 10,000 and is the maximum value of n. In order to ensure that the frequency F1 does not fall below the step frequency 10 kHz of phase lock loop 32 the coarse frequency phase lock loop 44 must be off set by at least one step and it is for this reason that the actual frequency division value of the variable frequency divider is m + 2. m + 2 is used rather than m + 1 due to the fact that in the pulse string synthesiser 34, the complement value is used.

Referring to Figure 3, F(41) = F(35) + F(34), but F(43) = F(47) - F1, where F(43) is the F2 output of the pulse string synthesiser 34, F(47) is the frequency on line 47 applied as the Fq input to the pulse string synthesiser 34, and F1 is the frequency value F1 as described in connection with Figures 1 and 2.

Combining these two expressions gives

F(41) = F(35) + F(47) - Fl

This m + 2 takes the value F(35) + F(47), and 2N - n is made equal to Fl. The choice of m + 2 and 2N - n ensures that the lowest value of frequency Fl is never less than N, and hence the fundamental jitter which is at frequency Fl can be removed by the low pass filter 42.

The reference frequency applied from terminal 30 to the pulse string synthesiser 34 may be raised if required by the frequency multiplier 33, thereby giving a higher value of the frequency Fq which enables the amplitude of the jitter frequency to be reduced for a given output frequency. It will be seen that the use of the pulse string synthesiser 34 in the circuit of Figure 3 enables the frequency F2 to be adjusted so as to enable the frequency values of the two oscillators 35 and 40 to be separated by a sufficient amount. Additionally, the off setting of the pulse string synthesiser 34 by one step value enables the jitter frequency Fl to be removed by the low pass filter 42.

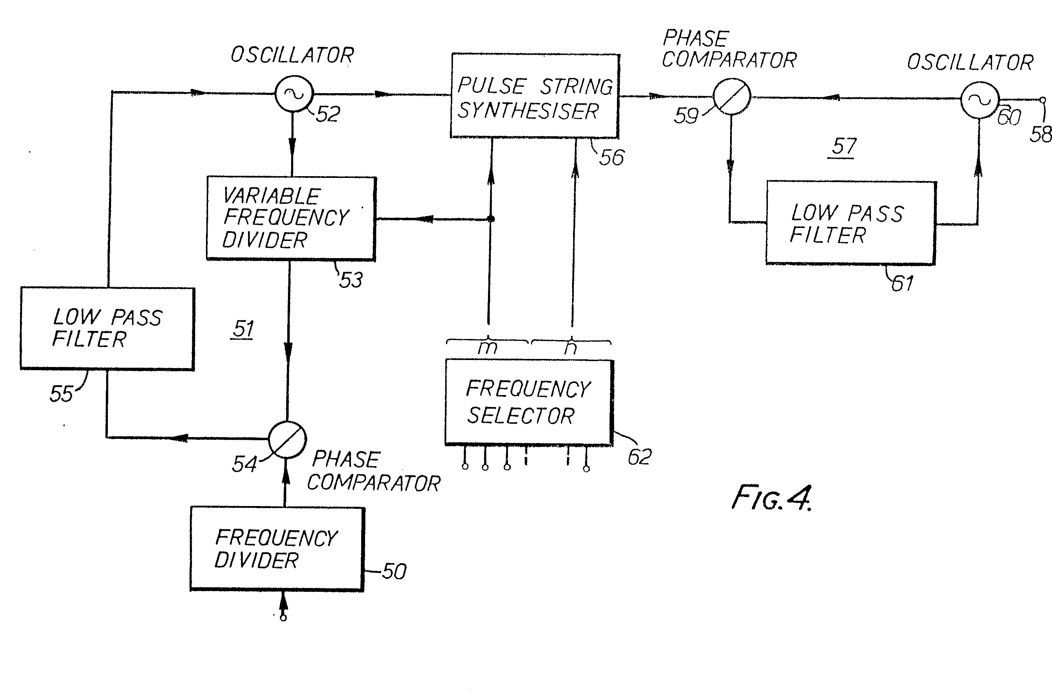

Another multi-stage frequency synthesiser in which the pulse string synthesiser can be used with advantage is shown in Figure 4 in which a reference frequency is applied to the frequency divider 50 to a phase lock loop 51. The phase lock loop 51 consists of an oscillator 52 which feeds its output via a variable frequency divider 53 to one input of a phase comparator 54, the other input of which is obtained from the frequency divider 50. The output of the phase comparator 54 is passed in conventional manner through a low pass filter 55 to control the operation of the variable frequency oscillator 52. The output of the oscillator 52 is applied to the input terminal of a pulse string synthesiser 56, the ouput of which is applied via a further phase lock loop 57 to an output terminal 58. The phase lock loop 57 consists of a phase comparator 59, one input of which receives an output frequency from the pulse string synthesiser 56 and the other input of which is obtained from a further variable oscillator 60. The output of the phase comparator 59 is passed via a low pass filter 61 to control and stabilise the operation of the oscillator 60 which provides the required output frequency.

The operation of the variable frequency divider 53 and the pulse string synthesiser 56 is controlled by a frequency selector 62, by means of which a required output frequency can be selected. It will be seen that the coarse frequency steps produced by the phase lock loop 51 are fed into the pulse string synthesiser 56 as the frequency Fq. The output frequency F2 is applied to the mixer 59 and its fundamental jitter frequency F1 is removed in the clean-up phase lock loop 57. Since the frequency provided by oscillator 52 is variable the pulse string synthesiser 56 must be provided with information concerning the value of frequency Fq so as to enable the calculation to be correctly performed, this calculation being as described with reference to Figures 1 and 2. A definite off-set frequency must be produced by the phase lock loop 51 so that the fundamental jitter frequency is always present above the cut off frequency value of the low pass filter 61, which forms part of the phase lock loop 57.

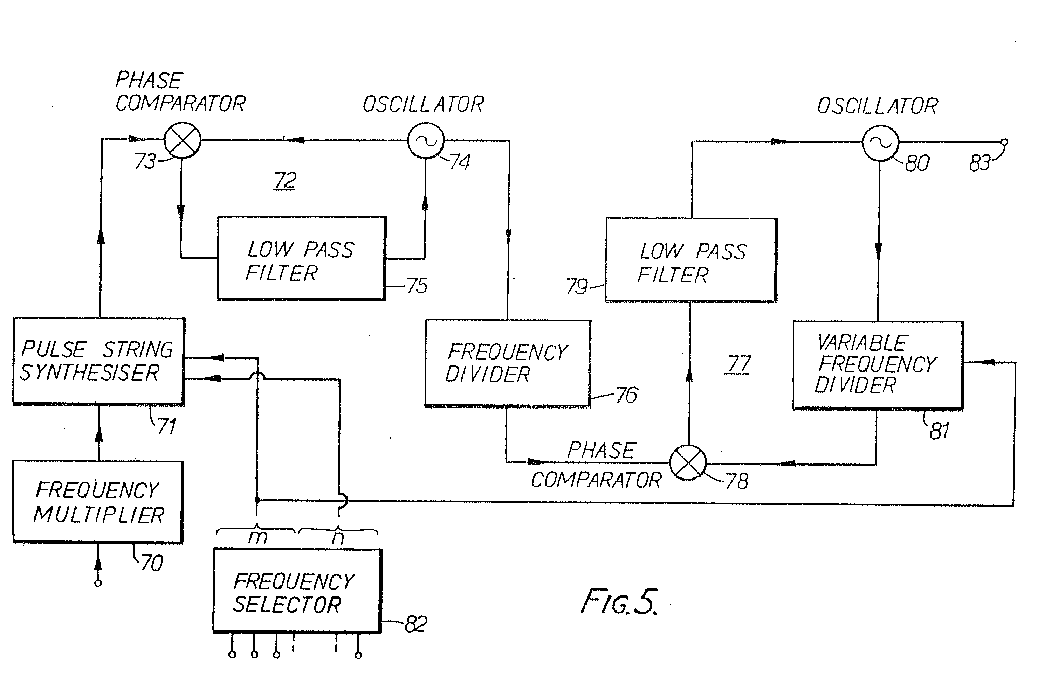

A further example of a frequency synthesiser which advantageously incorporates a pulse string synthesiser is shown in Figure 5. This synthesiser is of greater complexity and its use is intended for applications where residual jitter of the amplitude which would typically be produced by the circuits shown in Figures 3 and 4 is unacceptably large. In Figure 5, a reference frequency is applied via a frequency multiplier 70 to a pulse string synthesiser 71 which again could be of the form shown in Figures 1 or 2. The output of the pulse string synthesiser 71 is applied to a phase lock loop 72 comprising a phase comparator 73, an oscillator 74 and a low pass filter 75 arranged in conventional manner. The output of the oscillator 74 is applied via a fixed frequency divider 76 to a further phase lock loop 77, which consists of a phase comparator 78, a low pass filter 79, an output oscillator 80 and a variable frequency divider 81, again arranged in a conventional manner. The pulse string synthesiser 71 and the variable frequency divider 81 are both controlled by a frequency selector 82 by means of which the desired output frequency is selected.

The operation of Figure 5 is as follows. The phase lock loop 77 executes coarse frequency steps, and in addition also carries the small frequency steps required at the output terminal 83 by virtue of the fact that the reference frequency fed to its phase comparator 78 is altered by the action of the pulse string synthesiser 71. It is necessary for the pulse string synthesiser 71 to be informed of the output frequency provided at terminal 83, since it is this frequency from which it is off-set. In order to ensure that the value of the fundamental jitter frequency Fl is always sufficiently high so as to be attenuated by the filter 75 of the clean-up phase lock loop 72, a permanent off-set is required which is preferably equal to one small step of the phase lock loop 77.

Since the output frequency provided by the pulse string synthesiser 71 is required to change only very slightly, the oscillator 74 which forms part of the phase lock loop 72 may be a very stable crystal oscillator. Additionally the pass band of the filter 75 may be very low so as to improve the clean-up properties of the phase lock loop 72. As was stated in connection with Figures 1 and 2, the jitter frequency present at the output of the pulse string synthesiser 71 has the minimum possible value which is limited only by time quantisation, so there is no point in attempting to reduce it by frequency division. However, after the time quantisation has been removed by the phase lock loop 72 residual jitter on the output of the oscillator 74 can be reduced by the use of the fixed frequency divider 76. The presence of the frequency multiplier 70 at the input is optional and allows even further reduction of the residual jitter frequency by raising the frequency at which the whole system operates.

CLAIMS:-

1.     A method of synthesising an output signal having a mean frequency from a higher frequency by dividing the higher frequency by a non-integral divisor value having an integral portion and a fractional portion including the steps of receiving digital pulses at said higher frequency, frequency dividing said higher frequency by said integral portion of the divisor value to produce a stream of pulses; providing a control signal derived from a succession of cumulative sums of the fractional portions of the divisor values and which is indicative of fractional portions of the cumulative sums which exceed a predetermined amount; and utilising said control signal to remove a pulse from said received digital pulses prior to frequency division in response to the generation of a pulse in said stream of pulses.

2.     A frequency synthesiser which synthesises an output signal having a mean frequency from a higher frequency by dividing the higher frequency by a non-integral divisor value having an integral portion and a fractional portion including means for receiving digital pulses at said higher frequency; a frequency divider for dividing said higher frequency by said integral portion of the divisor value to produce a stream of pulses; means for providing a control signal derived from a succession of cumulative sums of the fractional portions of the divisor values and which is indicative of fractional portions of the cumulative sums which exceed a predetermined amount and means for utilising said control signal to remove a pulse from said received digital pulses prior to frequency division in response to the generation of a pulse in said stream of pulses.

3.     A synthesiser as claimed in claim 2 and wherein said stream of pulses is provided as an output signal.

4.     A synthesiser as claimed in claim 2 and wherein said stream of pulses is subtracted from the digital pulses at said higher frequency to form a difference frequency which is provided as an output frequency.

5. A synthesiser as claimed in claim 2, 3 or 4 and wherein a pulse is removed from said received digital pulses prior to frequency division each time said cumulative sum exceeds unity.

6. A synthesiser as claimed in claim 2, 3, 4 or 5 and wherein the cumulative summation is performed in a summation circuit which is clocked by means of pulses of said stream of pulses, so that the fractional portions are cumulatively summed each time a pulse of said stream of pulses is produced.

7. A synthesiser as claimed in claim 6 and wherein each time said fractional portion of said cumulative sum exceeds the predetermined amount, the output of the summation circuit enables a pulse subtractor to remove the pulse from said received digital pulses.

8. A synthesiser as claimed in claim 7 and wherein the summation circuit controls a gate which when opened allows a single pulse of said stream of pulses to pass to said pulse subtractor.

9. A synthesiser as claimed in claim 2, 3, 4 or 5 and wherein all successive values of the cumulative sum are initially calculated and stored so as to enable a pulse to be removed from said received digital pulses as required in response to pulses in said stream of pulses.

10. A synthesiser as claimed in claim 9 and wherein storage means are provided for storing a sequence of digits, a first digital value or a second digital value being produced when the fractional portion of the cumulative sum is respectively greater or less than the predetermined amount, clocking means for reading said storage means under the action of clock signals derived from said stream of pulses, whereby a pulse is removed from said received digital pulses prior to frequency division each time a said first digital value is read from the store.

11. A multi-stage frequency synthesiser including a plurality of frequency changing stages, at least one stage of which comprises a frequency synthesiser as claimed in any of the preceding claims.

12. A multi-stage frequency synthesiser as claimed in claim 11 and wherein at least one further stage of the plurality of frequency changing stages comprises a phase lock loop which includes in the loop a sequence of circuit elements comprising a frequency controllable oscillator, a variable frequency divider, a phase comparator arranged to compare the frequency of the signal provided by said variable frequency divider with a reference frequency, and to control the frequency of said frequency controllable oscillator in dependence on said comparison.

13. A multi-stage frequency synthesiser as claimed in claim 12 and wherein said reference frequency which is applied to the phase comparator is a variable frequency derived from said one stage which comprises a frequency synthesiser as claimed in any of claims 1 to 10.

14. A multi-stage frequency synthesiser as claimed in claim 12 and wherein a signal, which is applied as said higher frequency to said one stage which comprises a frequency synthesiser as claimed in any of claims 1 to 10, is derived from a frequency controllable oscillator forming part of a said further stage of the multi-stage frequency synthesiser.

1/5

0019412

Fig.1.

Fq

PULSE
SUBTRACTOR

F2

SHIFT
REGISTER

CALCULATOR

FRACTIONAL
LATCH

PULSE
SUBTRACTOR

VARIABLE
FREQUENCY
DIVIDER

INTEGRAL
LATCH

CALCULATOR

FREQUENCY SELECTOR

F1

FIG.2.

Fig.3

FIG.4.

4/5

0019412

FIG.5.

European Patent Office

**EUROPEAN SEARCH REPORT**

| | DOCUMENTS CONSIDERED TO BE RELEVANT | | CLASSIFICATION OF THE APPLICATION (Int. Cl.) |
|---|---|---|---|
| Category | Citation of document with indication, where appropriate, of relevant passages | Relevant to claim | |
| | US - A - 3 976 945 (R.G. COX)<br>* fig. 1 to 3 *<br>-- | 1 | H 03 L 7/18<br>H 03 B 21/02<br>H 03 K 21/36 |
| A | US - A - 4 145 667 (D.G. MESSERSCHMITT)<br>* fig. 1, 2 *<br>-- | | |
| A | US - A - 4 034 302 (C.J. MAY, JR.)<br>* fig. 1 to 7 *<br>-- | | TECHNICAL FIELDS SEARCHED (Int.Cl.) |
| A | US - A - 3 882 403 (W.G. GERKEN)<br>* fig. 1 to 4 *<br>-- | | H 03 B 21/00<br>H 03 K 21/00<br>H 03 L 7/00 |
| A | US - A - 3 849 635 (D.D. FREEDMAN)<br>* fig. 1 to 3 *<br>---- | | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| X | The present search report has been drawn up for all claims | | |
|---|---|---|---|
| Place of search | Date of completion of the search | Examiner | |
| Berlin | 15-08-1980 | BREUSING | |

EPO Form 1503.1 06.78